# EUROPEAN PATENT SPECIFICATION

(11) **EP 2 416 630 B1**
(45) Date of publication and mention of the grant of the patent: **07.10.2015**
(21) Application number: 11159293.7
(22) Date of filing: 22.03.2011
(51) Int. Cl.: H05K 3/34, H05K 1/02, H05K 1/05

(54) **Circuit board and manufacturing method thereof**
Platine und Verfahren zu deren Herstellung
Carte de circuit et son procédé de fabrication

(30) Priority: 23.11.2010 TW 099140396; 05.08.2010 TW 099215014; 18.11.2010 EP 10191781
(43) Date of publication of application: 08.02.2012
(73) Proprietor: Unimicron Technology Corp., Taoyuan (TW)
(72) Inventor: Tseng, Tzyy-Jang, Hsinchu City 300 (TW); Lee, Chang-Ming, Dayuan Township Taoyuan County 337 (TW); Liu, Wen-Fang, Zhongli City Taoyuan County 320 (TW); Yu, Cheng-Po, Zhongli City Taoyuan County 320 (TW)
(74) Representative: Viering, Jentschura & Partner Patent- und Rechtsanwälte

(56) References cited:
- JP-A- 4 180 689
- JP-A- 4 180 690
- US-A1- 2007 035 013
- US-B1- 6 570 099

## Description

### BACKGROUND OF THE INVENTION

### Field of Invention

The present invention relates to a circuit board and a manufacturing method thereof, and more particularly, to a circuit board that can accelerate the thermal energy transfer rate and a manufacturing method thereof.

### Related Art

The current electronic devices, such as mobile phones and computers, and the household appliances, such as televisions and refrigerators, include a plurality of electronic components, for example, active components or passive components. Most of the electronic components are mounted on a circuit substrate, and the electronic components output and receive electrical signals by using the circuitry of the circuit substrate. Thus, the electrical signals can be transmitted among the electronic components.

However, the electronic components will generate some thermal energy during the operation, and some electronic components, such as light-emitting diodes (LEDs) and power components, even generate a large amount of thermal energy during the operation. Therefore, how to accelerate the thermal energy transfer rate of the electronic components is a subject worth studying.

In order to improve energy management JP 4 180 690 A (cf. the preamble of claims 1, 6 and 8) discloses electrically insulating layers having different thermal conductivity, while US 6,570,099 B1 proposes a thermal conductive substrate.

### SUMMARY OF THE INVENTION

The present invention is directed to a circuit board enabling to accelerate the thermal energy transfer rate of electronic components according to claim 1, 6 and 8. Advantageous embodiments are subject matter of the dependent claims.

The present invention provides a circuit board including a metal pattern layer, a thermally conductive plate, an electrically insulating layer, and at least one electrically insulating material. The thermally conductive plate has a plane. The electrically insulating layer is disposed between the metal pattern layer and the plane and partially covers the plane. The electrically insulating material covers the plane where is not covered by the electrically insulating layer, and touches the thermally conductive plate. The electrically insulating layer exposes the electrically insulating material, and a thermal conductivity of the electrically insulating material is larger than the thermal conductivity of the electrically insulating layer.

In manufacturing an electrically insulating layer and at least one electrically insulating material are formed on a plane of a thermally conductive plate, and a metal pattern layer located on the electrically insulating layer is formed. The electrically insulating layer partially covers the plane, and the electrically insulating material covers the plane where is not covered by the electrically insulating layer. The electrically insulating material touches the thermally conductive plate. A thermal conductivity of the electrically insulating material is larger than that of the electrically insulating layer.

Based on the above, the thermal conductivity of the electrically insulating material is larger than the thermal conductivity of the electrically insulating layer, and the electrically insulating material covers the plane where is not covered by the electrically insulating layer and touches the thermally conductive substrate, so that the electrically insulating material and the thermally conductive substrate can accelerate the thermal energy transfer rate when operating electronic components generate thermal energy.

To make the features and advantages of the present invention more clear and understandable, the present invention will be described below in great detail through the embodiments in combination with the accompanying drawings.

### BRIEF DESCRIPTION OF THE DRAWINGS

The present invention will become more fully understood from the detailed description given herein below for example only, and thus are not limitative of the present invention, and wherein:
FIG. 1 is a cross-sectional schematic view of a circuit board;
FIG 2 is a cross-sectional schematic view of a further circuit board;
FIG. 3 is a cross-sectional schematic view of a circuit board according to an embodiment of the present invention;
FIG 4 is a cross-sectional schematic view of a circuit board according to another embodiment of the present invention;
FIG 5A to FIG. 5C are cross-sectional schematic flow charts of a manufacturing method of a circuit board; and
FIG 6A to FIG. 6C are cross-sectional schematic flow charts of a manufacturing method of a circuit board.

### DETAILED DESCRIPTION OF THE INVENTION

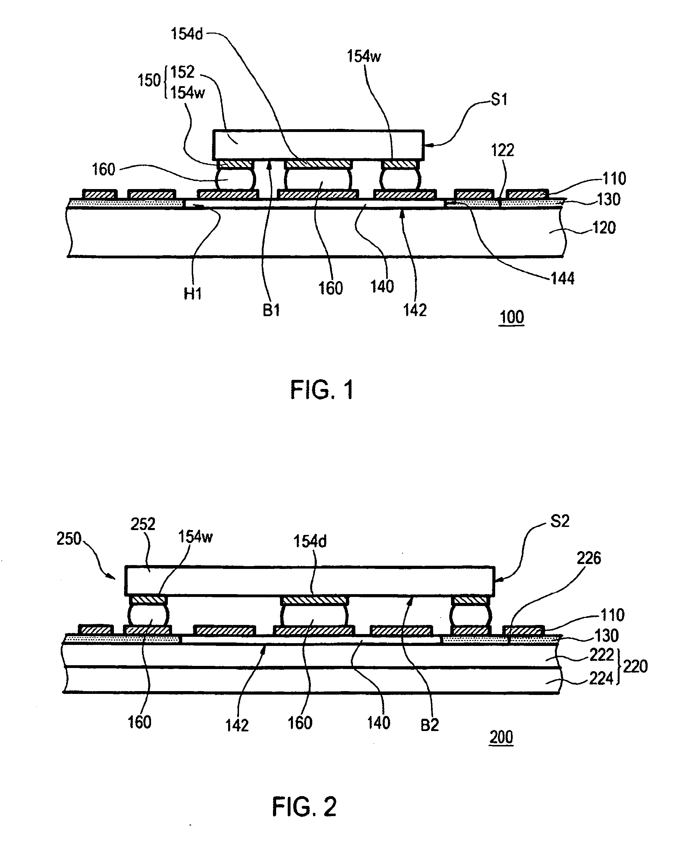

FIG. 1 is a cross-sectional schematic view of a circuit board not covered by the present invention but beneficial for understanding the present invention. Referring to FIG. 1, a circuit board 100 includes a metal pattern layer 110, a thermally conductive plate 120, an electrically insulating layer 130, and an electrically insulating material 140. The thermally conductive plate 120 has a plane 122, and both the electrically insulating layer 130 and the electrically insulating material 140 are disposed between the metal pattern layer 110 and the plane 122.

The electrically insulating layer 130 partially covers the plane 122, that is, the electrically insulating layer 130 does not completely cover the plane 122, and a part of the plane 122 is not covered by the electrically insulating layer 130. The electrically insulating material 140 covers the plane 122 where is not covered by the electrically insulating layer 130, and the electrically insulating layer 130 exposes the electrically insulating material 140. The electrically insulating material 140 touches the thermally conductive plate 120 and further touches the metal pattern layer 110, and thus can be thermally coupled to the thermally conductive plate 120 and the metal pattern layer 110. Therefore, thermal energy can be transferred between the electrically insulating material 140 and the thermally conductive plate 120 in the manner of thermal conduction.

The thermally conductive plate 120 has a high thermal conductivity, for example, larger than 1 W/MK. The thermally conductive plate 120 may be a metal plate or a carbon-material board. The carbon-material board generally refers to a plate made of carbon, such as a carbon fiber plate or a graphite plate. The metal plate may be an alloy plate or a plate substantially made of a single kind of metal, such as an aluminum-magnesium alloy plate, aluminum plate, or copper plate.

The electrically insulating material 140 may be a ceramic layer, thermal pad, or thermal adhesive layer, in which the thermal pad is a solid. The thermal adhesive layer generally refers to a film formed of an adhesive having a high thermal conductivity, such as a thermal adhesive, in which the thermal adhesive may be in liquid state or colloidal state. In addition, both the thermal pad and the thermal adhesive may include a plurality of particles having a capability of high thermal conductivity, such as a metal particle, carbon powder, or silicon carbide (SiC) powder.

It should be noted that, although FIG. 1 only depicts one electrically insulating material 140, in other embodiment, the circuit board 100 may include a plurality of electrically insulating materials 140. In other words, one or more electrically insulating materials 140 may be included by the circuit board 100. Therefore, the number of the electrically insulating material 140 shown in FIG. 1 is only for example and does not limit the present invention.

The thermal conductivity of the electrically insulating material 140 is larger than the thermal conductivity of the electrically insulating layer 130 so that the thermal energy transfer rate of the electrically insulating material 140 will be larger than the thermal energy transfer rate of the electrically insulating layer 130, in which the thermal conductivity of the electrically insulating layer 130 may be lower than 1 W/MK. For example, the thermal conductivity of the electrically insulating layer 130 may be between 0.3 W/MK and 0.5 W/MK, and the thermal conductivity of the electrically insulating material 140 may be larger than 2.0 W/MK. It should be noted that the thermal conductivity mentioned in the present invention is obtained at an absolute temperature of 300K. In addition, both the electrically insulating layer 130 and the electrically insulating material 140 may be formed in the manner of laminating or printing.

When the electrically insulating layer 130 and the electrically insulating material 140 are formed in the manner of laminating, the electrically insulating layer 130 may be a prepreg, and the electrically insulating material 140 may be a thermal pad, that is, both the electrically insulating layer 130 and the electrically insulating material 140 may be formed by laminating the prepreg and the thermal pad. In addition, before laminating the prepreg, the prepreg may be punched, routed, or laser-ablated, thereby forming an opening H1 in the electrically insulating layer 130 and making the thermal pad disposed in the opening H1.

When the electrically insulating layer 130 and the electrically insulating material 140 are formed in the manner of printing, the electrically insulating material 140 may be a ceramic layer or a thermal adhesive layer. The electrically insulating layer 130 and the electrically insulating material 140 may be formed by applying a liquid, colloidal, or paste-like coating. The coating may be resin or a coating containing resin. In addition, when the electrically insulating layer 130 and the electrically insulating material 140 are formed in the manner of printing, after the coating is applied, the coating may be heated and dried or illuminated by light to cure the coating, in which the light may be ultraviolet light.

The circuit board 100 may further include an electronic component 150, such as a light-emitting diode, a power component, a die package, or a die. The electronic component 150 includes a component main body 152 and a plurality of pads 154d and 154w. The component main body 152 has a bottom surface B1, and the pads 154d and 154w are disposed on the bottom surface B1. The pad 154d may be a dummy pad, and the pad 154w may be a working pad. When the electronic component 150 is in operation, a current may just pass through the pad 154w without passing through the pad 154d.

It should be noted that, Although FIG. 1 only depicts one electronic component 150, in other embodiment, the circuit board 100 may include a plurality of electronic components 150. That is to say, one or more electronic components 150 may be included by the circuit board 100. Therefore, the number of the electronic component 150 shown in FIG. 1 is only for example and does not limit the present invention.

The electronic component 150 may be electrically connected to the metal pattern layer 110 in the manner of flip chip, as shown in FIG. 1. Particularly, the circuit board 100 may further include a plurality of solders 160 connected to the electronic component 150 and the thermally conductive plate 120. Each solder 160 is connected to one of the pads 154w or 154d, and the solders 160 touch the pads 154w and 154d and the metal pattern layer 110. Therefore, the pads 154w and 154d may be electrically connected to the metal pattern layer 110 through the solders 160 and may further be thermally coupled to the electrically insulating material 140 through the solders 160 and the metal pattern layer 110.

In the embodiment in FIG. 1, the pads 154w and 154d are thermally coupled to the electrically insulating material 140 through the solders 160 and the metal pattern layer 110. However, in other embodiment, when the pad 154d is a dummy pad, the pad 154d may be thermally coupled to the electrically insulating material 140 through the solders 160 without the metal pattern layer 110, and the pad 154d even may directly touch the electrically insulating material 140, instead of being thermally coupled to the electrically insulating material 140 through the solders 160. Therefore, even if there are no solder 160 existing, and electrically insulating material 140 does not touch the metal pattern layer 110, the pad 154d also may be directly thermally coupled to the electrically insulating material 140.

Based on the above, the pads 154w and 154d are thermally coupled to the electrically insulating material 140, and the electrically insulating material 140 is thermally coupled to the thermally conductive plate 120, so that the electrically insulating material 140 and the thermally conductive plate 120 can accelerate the thermal energy transfer rate, thereby reducing the probability that the electronic component 150 is overheating when the operating electronic component 150 generates thermal energy.

In addition, the electrically insulating material 140 covers the plane 122 where is not covered by the electrically insulating layer 130, and the electrically insulating material 140 is exposed by the electrically insulating layer 130, so the electrically insulating material 140 does not completely cover the plane 122 of the thermally conductive plate 120, thereby enabling to limit the amount of usage of the electrically insulating material 140 for the circuit board 100. Moreover, the material cost of the electrically insulating material 140 with a high thermal conductivity is usually higher than the material cost of the electrically insulating layer 130 with a small thermal conductivity. Therefore, since the amount of usage of the electrically insulating material 140 can be limited, the overall manufacturing cost of the circuit board 100 in this embodiment can be reduced.

It should be noted that, in addition to the flip chip, the electronic component 150 also may be electrically connected to the metal pattern layer 110 in other manners. For example, the electronic component 150 may be electrically connected to the metal pattern layer 110 in the manner of wire bonding. Therefore, the manner of electrical connection between the electronic component 150 and the metal pattern layer 110 shown in FIG. 1 is only for example and does not limit the present invention.

The component main body 152 further has a side surface S1 connected to the bottom surface B1. The electrically insulating material 140 has a contact surface 142 touching the thermally conductive plate 120 and a side edge 144 connected to the contact surface 142. The area of the bottom surface B1 may be smaller than the area of the plane 122 covered by the electrically insulating material 140, that is, the area of the bottom surface B1 may be smaller than the area of the contact surface 142.

Further, in this embodiment, the electrically insulating material 140 may protrude from the side surface S1, and the component main body 152 may not protrude from the side edge 144. Thus, the component main body 152 may be completely located within the contact surface 142. Therefore, most of the thermal energy from the electronic component 150 is transferred by the electrically insulating material 140, so as to reduce the probability that the electronic component 150 is overheating.

FIG. 2 is a cross-sectional schematic view of a circuit board covered by the present invention. Referring to FIG. 2, a circuit board 200 in this embodiment is similar to the circuit board 100 in the above embodiment. For example, both of the circuit board 100 and the circuit board 200 include some identical components, and the difference between the two only lies in a thermally conductive plate 220 and an electronic component 250 included by the circuit board 200.

Particularly, the thermally conductive plate 220 has a multilayer structure, and a component main body 252 included by the electronic component 250 has a bottom surface B2 and a side surface S2 connected to the bottom surface B2. The area of the bottom surface B2 is larger than the area of the plane 226 covered by the electrically insulating material 140, that is, the area of the bottom surface B2 is larger than the area of the contact surface 142, and the electrically insulating material 140 does not protrude from the side surface S2 of the component main body 252.

The thermally conductive plate 220 includes a thermally conductive layer 222 and a main body layer 224. The thermally conductive layer 222 is located between the main body layer 224 and the electrically insulating layer 130 and touches the electrically insulating material 140. The thermally conductive layer 222 has a high thermal conductivity, for example, higher than 1 W/MK. The thermally conductive layer 222 is a carbon-material layer. The carbon-material layer generally refers to a film mainly formed by carbon, such as a carbon fiber layer, a graphite layer, or a diamond film. Therefore, the thermally conductive plate 220 also can accelerate the thermal energy transfer rate, so as to reduce the probability that the electronic component 250 is overheating.

It should be noted that, the electronic component 250 further includes a plurality of pads 154d and 154w, and only one pad 154d is thermally coupled to the electrically insulating material 140, as shown in FIG. 2. However, both the pads 154w and 154d also can be thermally coupled to the electrically insulating material 140. In addition, in the circuit board 200 shown in FIG. 2, the thermally conductive plate 220 may be replaced by the thermally conductive plate 120 in FIG. 1. Therefore, the pads 154d and 154w and the thermally conductive plate 220 shown in FIG. 2 are only for example and do not limit the present invention.

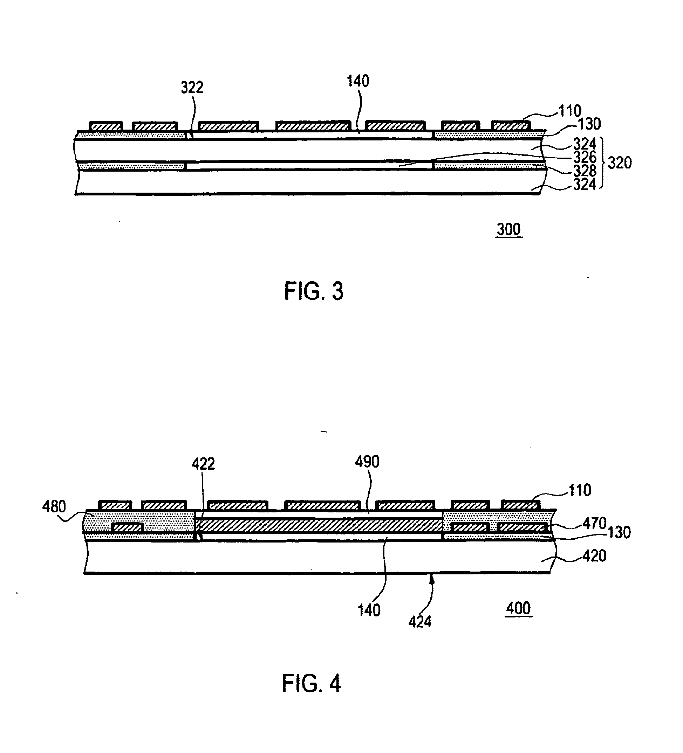

FIG. 3 is a cross-sectional schematic view of a circuit board according to the present invention. Referring to FIG. 3, a circuit board 300 in this embodiment is similar to the circuit board 200 in the above embodiment. For example, both of the circuit board 200 and the circuit board 300 include some identical components, and the electronic component 150 or 250 (referring to FIG. 1 and FIG. 2) may be electrically connected to the metal pattern layer 110 of the circuit board 300 in the manner of flip chip or wire bonding. However, there is a difference between the circuit board 200 and 300, and the difference lies in that: a thermally conductive plate 320 included by the circuit board 300 is different from the thermally conductive plate 220.

Particularly, the thermally conductive plate 320 includes a plurality of thermally conductive substrates 324, at least one thermally conductive pattern 326, and at least one inner electrically insulating layer 328. Both the thermally conductive pattern 326 and the inner electrically insulating layer 328 are disposed between the thermally conductive substrates 324, and the thermally conductive pattern 326 and the inner electrically insulating layer 328 touch the thermally conductive substrates 324, as shown in FIG. 3.

One of the thermally conductive substrates 324 has a plane 322, and the metal pattern layer 110, the electrically insulating layer 130, and the electrically insulating material 140 are all disposed on the plane 322. Both the electrically insulating layer 130 and the electrically insulating material 140 are disposed between the metal pattern layer 110 and the plane 322 and touch the plane 322, in which the electrically insulating layer 130 partially covers the plane 322, and the electrically insulating material 140 covers the plane 322 where is not covered by the electrically insulating layer 130. In addition, in the embodiment in FIG. 3, the electrically insulating material 140 also may touch the metal pattern layer 110.

The thermally conductive substrate 324 has a high thermal conductivity, for example, larger than 1 W/MK, so the thermally conductive substrates 324 can accelerate the thermal energy transfer rate. In addition, each of the thermally conductive substrates 324 may be a metal plate or a carbon-material board, such as a carbon fiber plate or a graphite plate. The metal plate may be an alloy plate or a plate substantially made of a single kind of metal, such as an aluminum-magnesium alloy plate, an aluminum plate, or a copper plate.

The material of the thermally conductive pattern 326 may be the same as the material of the electrically insulating material 140 and may be a ceramic layer, a thermal pad, or a thermal adhesive layer. The forming method of the thermally conductive pattern 326 may be the same as the forming method of the electrically insulating material 140, and both the material and the forming method of the inner electrically insulating layer 328 may be the same as those of the electrically insulating layer 130, so both the thermally conductive pattern 326 and the inner electrically insulating layer 328 may be formed in the manner of laminating or printing.

Since the material of the thermally conductive pattern 326 may be the same as the material of the electrically insulating material 140, and the material of the inner electrically insulating layer 328 may be the same as the material of the electrically insulating layer 130, the thermal conductivity of the thermally conductive pattern 326 is larger than the thermal conductivity of the inner electrically insulating layer 328, and thus the thermal energy transfer rate of the thermally conductive pattern 326 is larger than the thermal energy transfer rate of the inner electrically insulating layer 328. In addition, the thermal conductivity of the inner electrically insulating layer 328 may be lower than 1 W/MK. For example, the thermal conductivity of the inner electrically insulating layer 328 may be between 0.3 W/MK and 0.5 W/MK, and the thermal conductivity of the thermally conductive pattern 326 may be larger than 2.0 W/MK.

In view of the above, when the electronic component 150 or 250 electrically connected to the metal pattern layer 110 is in operation, the thermally conductive pattern 326 and the thermally conductive substrates 324 can fast transfer the thermal energy generated by the electronic component 150 or 250. Therefore, the thermally conductive plate 320 can accelerate the thermal energy transfer rate, so as to reduce the probability that the electronic component 150 is overheating.

It should be noted that, although FIG. 3 depicts two thermally conductive substrates 324, only one thermally conductive pattern 326, and only one inner electrically insulating layer 328, in other embodiment, the circuit board 300 may include three or more thermally conductive substrates 324, a plurality of thermally conductive patterns 326, and a plurality of inner electrically insulating layers 328. Each of the thermally conductive patterns 326 and each of the inner electrically insulating layers 328 are located between two adjacent thermally conductive substrates 324. Therefore, the numbers of the thermally conductive substrate 324, the thermally conductive pattern 326, and the inner electrically insulating layer 328 shown in FIG. 3 are only for example and do not limit the present invention.

FIG. 4 is a cross-sectional schematic view of a circuit board according to another embodiment of the present invention. Referring to FIG. 4, a circuit board 400 in this embodiment is similar to the circuit board 100 in FIG. 1. For example, both of the circuit board 400 and the circuit board 100 include some identical components, and the electronic component 150 or 250 (referring to FIG. 1 and FIG. 2) may be electrically connected to the metal pattern layer 110 of the circuit board 400 in the manner of flip chip or wire bonding. In order to make the following contents concise, the difference between the circuit board 100 and the circuit board 400 will be mainly described hereinafter, and the same technical features of the circuit board 100 and the circuit board 400 will not be introduced again.

The circuit board 400 includes a metal pattern layer 110, an electrically insulating layer 130, an electrically insulating material 140, a thermally conductive plate 420, at least one inner metal pattern layer 470, at least one outer electrically insulating layer 480, and at least one electrically insulating material 490. The thermally conductive plate 420 can accelerate the thermal energy transfer rate and be the thermally conductive plate 120, 220, or 320 in the above embodiments.

The inner metal pattern layer 470 is disposed between the metal pattern layer 110 and the electrically insulating layer 130, and both the outer electrically insulating layer 480 and the outer electrically insulating material 490 are disposed between the inner metal pattern layer 470 and the metal pattern layer 110. The outer electrically insulating layer 480 covers the inner metal pattern layer 470, and the outer electrically insulating material 490 is located inside the outer electrically insulating layer 480.

The outer electrically insulating layer 480 exposes the outer electrically insulating material 490, and both the outer electrically insulating material 490 and the outer electrically insulating layer 480 may touch the metal pattern layer 110 and the inner metal pattern layer 470 and cover the inner metal pattern layer 470. However, in other embodiment, the electrically insulating material 140 may touch the outer electrically insulating material 490, and the outer electrically insulating material 490 may not touch the inner metal pattern layer 470.

The thermal conductivity of the outer electrically insulating material 490 is larger than the thermal conductivity of the outer electrically insulating layer 480. For example, the thermal conductivity of the outer electrically insulating layer 480 may be lower than 1 W/MK, such as between 0.3 W/MK and 0.5 W/MK, and the thermal conductivity of the outer electrically insulating material 490 may be larger than 2.0 W/MK. Both the material and forming method of the outer electrically insulating material 490 may be the same as those of the electrically insulating material 140, and both the material and forming method of outer electrically insulating material 490 also may be the same as those of the electrically insulating material 140, so that both the outer electrically insulating material 490 and the outer electrically insulating layer 480 may be formed in the manner of laminating or printing.

When the electronic component 150 or 250 electrically connected to the metal pattern layer 110 is in operation, the outer electrically insulating material 490, the electrically insulating material 140, and the thermally conductive substrates 324 can fast transfer the thermal energy generated by the electronic component 150 or 250. Therefore, the outer electrically insulating material 490, the inner metal pattern layer 470, the electrically insulating material 140, and the thermally conductive plate 420 can accelerate the thermal energy transfer rate, so as to reduce the probability that the electronic component 150 is overheating.

It should be noted that, although FIG. 4 depicts one inner metal pattern layer 470, one outer electrically insulating layer 480, and one outer electrically insulating material 490, in other embodiment, the circuit board 400 may include a plurality of inner metal pattern layers 470, a plurality of outer electrically insulating layers 480, and a plurality of outer electrically insulating materials 490.

The outer electrically insulating layers 480 and the inner metal pattern layers 470 may be alternately stacked, and each of the outer electrically insulating materials 490 is located inside one of the outer electrically insulating layers 480. Therefore, the numbers of the inner metal pattern layer 470, the outer electrically insulating layer 480, and the outer electrically insulating material 490 shown in FIG. 4 are only for example and do not limit the present invention.

In addition, there is a circuit board with a symmetrical structure in the technical field of the current circuit board, and the circuit board 400 also may have the symmetrical structure. Particularly, in other embodiment, the circuit board 400 may include a plurality of metal pattern layers 110, a plurality of electrically insulating layers 130, a plurality of electrically insulating materials 140, a plurality of inner metal pattern layers 470, a plurality of outer electrically insulating layers 480, and a plurality of outer electrically insulating materials 490.

The metal pattern layers 110, the electrically insulating layers 130, the electrically insulating materials 140, the inner metal pattern layers 470, the outer electrically insulating layers 480, and the outer electrically insulating materials 490 respectively take the thermally conductive plate 420 as a symmetry plane and are disposed in two opposite planes 422 and 424 of the thermally conductive plate 420 in line symmetry. The metal pattern layers 110 are disposed in an outermost side of the circuit board 400, and the electrically insulating layers 130 and the electrically insulating materials 140 respectively cover and touch the planes 422 and 424.

Since the symmetrical structure usually appears in some current circuit boards, even if the circuit board 400 with the symmetrical structure is not depicted, people having ordinary skill in the technical field of circuit board can understand the structure of the circuit board 400 with the symmetrical structure according to the embodiments. In other words, even if FIG. 4 does not disclose the circuit board 400 with the symmetrical structure, people having ordinary skill in the technical field of the present invention can know and implement the circuit board 400 with the symmetrical structure according to the above embodiment.

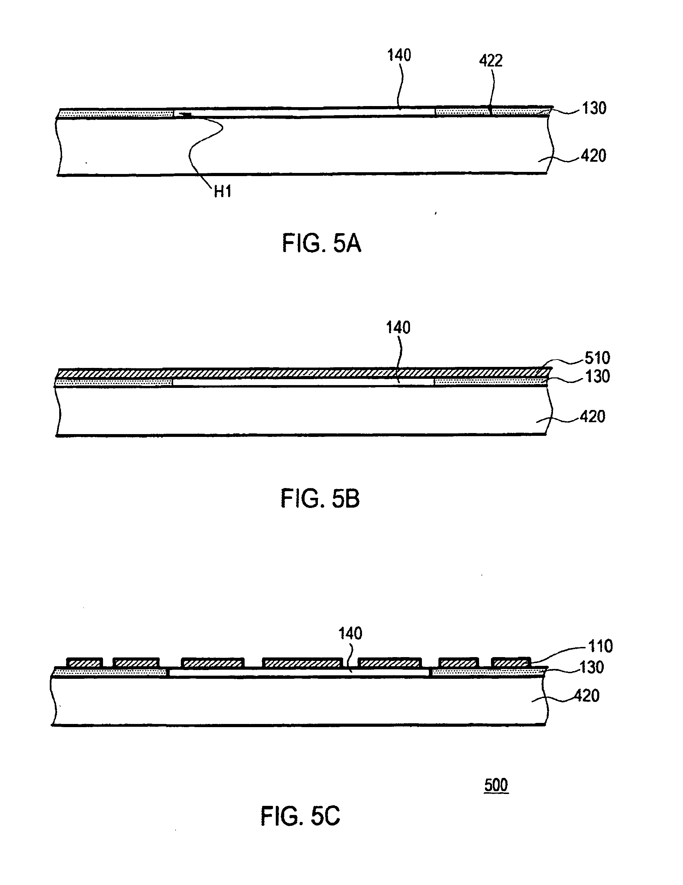

FIG. 5A to FIG. 5C are cross-sectional schematic flow charts of a manufacturing method of a circuit board according to an embodiment of the present invention, and the manufacturing method disclosed in FIG. 5A to FIG. 5C can be used to manufacture the circuit board 100, 200, 300, or 400 in FIG. 1 to FIG. 4. Referring to FIG. 5A, first, the electrically insulating layer 130 and at least one electrically insulating material 140 are formed on the plane 422 of the thermally conductive plate 420. The electrically insulating layer 130 partially covers the plane 422, and the electrically insulating material 140 covers the plane 422 where is not covered by the electrically insulating layer 130 and touches the thermally conductive plate 420.

The electrically insulating layer 130 and the electrically insulating material 140 may be formed by laminating or printing. Particularly, when the electrically insulating layer 130 and the electrically insulating material 140 are formed by laminating, the electrically insulating layer 130 may be a prepreg, and the electrically insulating material 140 may be a thermal pad. In the forming method of the electrically insulating layer 130 and the electrically insulating material 140, first, a prepreg (i.e. the electrically insulating layer 130) with at least one opening H1 is laminated on the plane 422. The opening H1 may be formed by punching or routing the prepreg, or ablating the prepreg by laser.

Then, a thermal pad (i.e. the electrically insulating material 140) is laminated on the plane 422, and the thermal pad is located in the opening H1. The electrically insulating layer 130 and the electrically insulating material 140 may be formed on the plane 422 so far. It can be known from the forming process of the electrically insulating layer 130 and the electrically insulating material 140 that the electrically insulating layer 130 may be formed before the electrically insulating material 140 is formed.

However, it should be noted that, in other embodiment, the thermal pad may be laminated on the plane 422 at first, thereby forming the electrically insulating material 140. Then, the prepreg with the opening H1 is laminated on the plane 422, so as to form the electrically insulating layer 130, so that the electrically insulating layer 130 also may be formed after the electrically insulating material 140 is formed. Therefore, the order for forming the electrically insulating layer 130 and the electrically insulating material 140 is not limited in the present invention.

When the electrically insulating layer 130 and the electrically insulating material 140 are formed by printing, the electrically insulating material 140 may be a ceramic layer or a thermal adhesive layer, and the electrically insulating layer 130 may be a resin layer. The electrically insulating layer 130 and the electrically insulating material 140 may be formed by applying a liquid, colloidal, or paste-like coating.

The method of forming the electrically insulating layer 130 and the electrically insulating material 140 may include applying two kinds of coatings. One of the coatings is used for forming the electrically insulating layer 130, and the other one is used for forming the electrically insulating material 140. In addition, the coatings may be applied on the plane 422, and after the coating is applied, the coating may be heated and dried or illuminated by light to cure the coating, in which the light may be ultraviolet light.

Referring to FIG. 5B, then, a metal foil 510 is laminated on the electrically insulating layer 130 and the electrically insulating material 140. The metal foil 510 is, for example, a copper foil, an aluminum foil, a tin foil, a silver foil, a gold foil, or a resin coated copper (RCC).

Referring to FIG. 5B to FIG. 5C, after the metal foil 510 is laminated, a part of the metal foil 510 is removed, so as to form the metal pattern layer 110 on the electrically insulating layer 130. The method of removing a part of the metal foil 510 may include lithography and etching. So far, the manufacturing of a circuit board 500 which can accelerate the thermal energy transfer rate is basically completed.

It should be noted that, in addition to the method of forming the metal pattern layer 110 disclosed in FIG. 5B and FIG. 5C, the metal pattern layer 110 also may be formed in other methods without laminating, lithography, and etching. For example, the method of forming the metal pattern layer 110 may include electroless plating and electroplating. Therefore, the metal pattern layer 110 also may be formed.

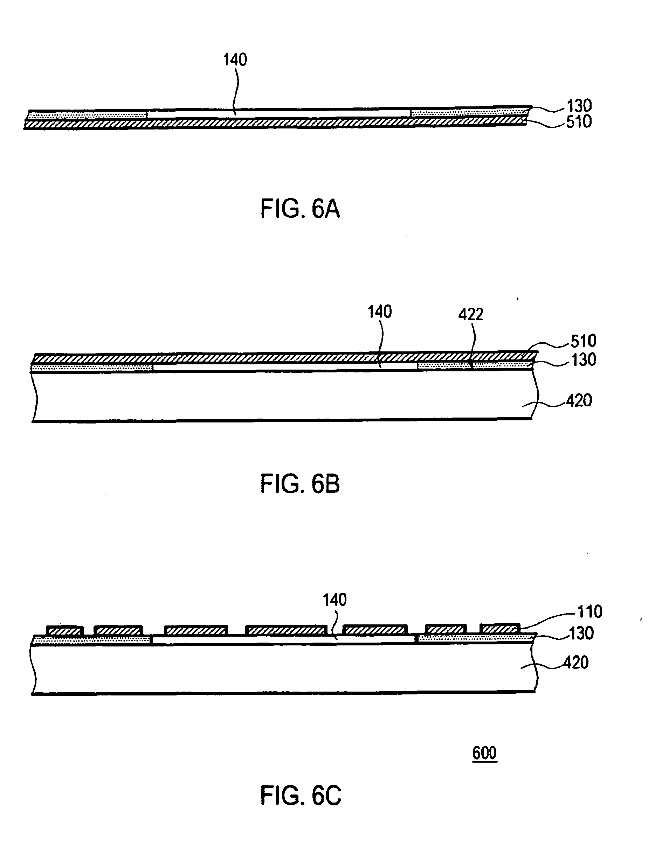

FIG. 6A to FIG. 6C are cross-sectional schematic flow charts of a manufacturing method of a circuit board according to another embodiment, and the manufacturing method disclosed in FIG. 6A to FIG. 6C can be used to manufacture the circuit board 100, 200, 300, or 400 in FIG. 1 to FIG. 4. Referring to FIG. 6A, first, the electrically insulating layer 130 and the electrically insulating material 140 are formed on the metal foil 510. Both the electrically insulating layer 130 and the electrically insulating material 140 touch the metal foil 510. The electrically insulating layer 130 and the electrically insulating material 140 may be formed by applying two kinds of coatings to the metal foil 510, and both the coatings may be sticky and contain the resin.

Referring to FIG. 6B, then, the thermally conductive plate 420 is provided, and the metal foil 510 is laminated on the plane 422 of the thermally conductive plate 420. The electrically insulating layer 130 and the electrically insulating material 140 are located between the metal foil 510 and the plane 422. Since the coatings for forming the electrically insulating layer 130 and the electrically insulating material 140 are viscous, both the electrically insulating layer 130 and the electrically insulating material 140 may bind the metal foil 510 with the thermally conductive plate 420 after the metal foil 510 is laminated.

Referring to FIG. 6B and FIG. 6C, after the metal foil 510 is laminated, a part of the metal foil 510 is removed, so as to form the metal pattern layer 110. The method of removing a part of the metal foil 510 may include lithography and etching. So far, the manufacturing of a circuit board 600 which can accelerate the thermal energy transfer rate is basically completed.

## Claims

1. A circuit board (100) having,
at least one metal pattern layer (110);
a thermally conductive plate (320), having a plane (322);
at least one electrically insulating layer (130), disposed between the metal pattern layer (110) and the plane (322) and partially covering the plane (322); and
at least one electrically insulating material (140), covering the plane (322) where is not covered by the electrically insulating layer (130), and contacting with the thermally conductive plate (320), wherein the electrically insulating layer (130), exposes the electrically insulating material (140), and a thermal conductivity of the electrically insulating material (140) is larger than a thermal conductivity of the electrically insulating layer (130), **characterized in that**
the thermally conductive plate (320) comprises:
a plurality of thermally conductive substrates (324), wherein one of the thermally conductive substrates (324) has the plane (322);
at least one thermally conductive pattern (326), disposed between the thermally conductive substrates (324); and
at least one inner electrically insulating layer (328), disposed between the thermally conductive substrate (324), wherein both the thermally conductive pattern (326) and the inner electrically insulating layer (328) touch the thermally conductive substrates (324), and a thermal conductivity of the thermally conductive pattern (326) is larger than a thermal conductivity of the inner electrically insulating layer (328).

2. The circuit board (100) according to claim 1, wherein the electrically insulating material (140) further touches the metal pattern layer (110).

3. The circuit board (100) according to claim 1, further comprising at least one electronic component (150), wherein the electronic component (150) comprises:
a component main body (152), having a bottom surface (B1); and
a plurality of pads (154d, 154w), disposed on the bottom surface (B1) and electrically connected to the metal pattern layer (110), wherein at least one of the pads (154d, 154w) is thermally coupled to the electrically insulating material (140).

4. The circuit board (100) according to claim 3, further comprising a plurality of solders (160) connected to the electronic component (150) and the thermally conductive plate (120), wherein each solder (160) is connected to one of the pads (154d,154w), and the solders (160) touch the pads (154d,154w) and the metal pattern layer (110).

5. The circuit board (100) according to claim 3, wherein an area of the bottom surface (B1) is smaller than an area of the plane (122) covered by the electrically insulating material (140).

6. A circuit board (100) having
at least one metal pattern layer (110);
a thermally conductive plate (420), having a plane (422);
at least one electrically insulating layer (130), disposed between the metal pattern layer (110) and the plane (422) and partially covering the plane (422); and
at least one electrically insulating material (140), covering the plane (422) where is not covered by the electrically insulating layer (130), and contacting with the thermally conductive plate (420), wherein the electrically insulating layer (130) exposes the electrically insulating material (140), and a thermal conductivity of the electrically insulating material (140) is larger than a thermal conductivity of the electrically insulating layer (130), **characterized in that**
the circuit board further comprises
at least one inner metal pattern layer (470), disposed between the metal pattern layer (110) and the electrically insulating layer (130);
ar least one outer electrically insulating layer (480), disposed between the inner metal pattern layer (470) and the metal pattern layer (110), and covering the inner metal pattern layer (470); and
at least one outer electrically insulating material (490), disposed between the inner metal pattern layer (470) and the metal pattern layer (110) and located inside the outer electrically insulating layer (480), wherein a thermal conductivity of the outer electrically insulating material (490) is larger than that of the outer electrically insulating layer (480).

7. The circuit board (100) according to claim 6, wherein both the outer electrically insulating material (490) and the outer electrically insulating layer (480) touch the metal pattern layer (110) and the inner metal pattern layer (470).

8. A circuit board (100) having,
at least one metal pattern layer (110);
a thermally conductive plate (120), having a plane (122);
at least one electrically insulating layer (130), disposed between the metal pattern layer (110) and the plane (122) and partially covering the plane (122); and
at least one electrically insulating material (140), covering the plane (122) where is not covered by the electrically insulating layer (130), and contacting with the thermally conductive plate (120), wherein the electrically insulating layer (130), exposes the electrically insulating material (140), and a thermal conductivity of the electrically insulating material (140) is larger than a thermal conductivity of the electrically insulating layer (130), **characterized in that**
the thermally conductive plate (220) comprises a thermally conductive layer (222) and a main body layer (224), and the thermally conductive layer (222) is located between the main body layer (224) and the electrically insulating layer (130) and touches the electrically insulating material (140), wherein the thermally conductive layer (222) is a carbon-material layer.

9. The circuit board (100) according to claim 8, wherein an area of the bottom surface (B2) is larger than an area of the plane (122) covered by the electrically insulating material (140).

10. The circuit board (100) according to claim 8, wherein the component main body (152) further has a side surface (S1) connected to the bottom surface (B2), and the electrically insulating material (140) does not protrude from the side surface (S1).

11. The circuit board (100) according to claim 8, wherein the electrically insulating material (140) further touches the metal pattern layer (110).

12. The circuit board (100) according to claim 8, further comprising at least one electronic component (150), wherein the electronic component (150) comprises:
a component main body (152), having a bottom surface (B1); and
a plurality of pads (154d, 154w), disposed on the bottom surface (B1) and electrically connected to the metal pattern layer (110), wherein at least one of the pads (154d, 154w) is thermally coupled to the electrically insulating material (140).

13. The circuit board (100) according to claim 12, further comprising a plurality of solders (160) connected to the electronic component (150) and the thermally conductive plate (120), wherein each solder (160) is connected to one of the pads (154d, 154w), and the solders (160) touch the pads (154d, 154w) and the metal pattern layer (110).

## Patentansprüche

1. Eine Leiterplatte (100), aufweisend
zumindest eine Metallstrukturlage (110),
eine thermisch leitfähige Platte (320), welche eine Ebene (322) hat,
zumindest eine elektrisch isolierende Lage (130), welche zwischen der Metallstrukturlage (110) und der Ebene (322) angeordnet ist und partiell die Ebene (322) abdeckt, und
zumindest ein elektrisch isolierendes Material (140), welches die Ebene (322) dort abdeckt, wo sie nicht von der elektrisch isolierenden Lage (130) abgedeckt ist, und welches die thermisch leitfähige Platte (320) kontaktiert, wobei die elektrisch isolierende Lage (130) das elektrisch isolierende Material (140) exponiert und eine thermische Leitfähigkeit des elektrisch isolierenden Materials (140) größer ist als eine thermische Leitfähigkeit der elektrisch isolierenden Lage (130), **dadurch gekennzeichnet, dass**
die thermisch leitfähige Platte (320) aufweist:
eine Mehrzahl von thermisch leitfähigen Substraten (324), wobei eines der thermisch leitfähigen Substrate (324) die Ebene (322) hat,
zumindest eine thermisch leitfähige Struktur (326), welche zwischen den thermisch leitfähigen Substraten (324) angeordnet ist, und
zumindest eine innere elektrisch isolierende Lage (328), welche zwischen den thermisch leitfähigen Substraten (324) angeordnet ist, wobei sowohl die thermisch leitfähige Struktur (326) als auch die innere elektrisch isolierende Lage (328) die thermisch leitfähigen Substrate (324) berühren und eine thermische Leitfähigkeit der thermisch leitfähigen Struktur (326) größer ist als eine thermische Leitfähigkeit der inneren elektrisch isolierenden Lage (328).

2. Die Leiterplatte (100) gemäß Anspruch 1, wobei das elektrisch isolierende Material (140) weiter die Metallstrukturlage (110) berührt.

3. Die Leiterplatte (100) gemäß Anspruch 1, weiter zumindest eine elektronische Komponente (150) aufweisend, wobei die elektronische Komponente (150) aufweist:
einen Komponentenhauptkörper (152), welcher eine Bodenfläche (B1) hat, und
eine Mehrzahl von Auflagen (154d, 154w), welche an der Bodenfläche (B1) angeordnet sind und elektrisch mit der Metallstrukturlage (110) verbunden sind, wobei zumindest eine der Auflagen (154d, 154w) mit dem elektrisch isolierenden Material (140) thermisch gekuppelt ist.

4. Die Leiterplatte (100) gemäß Anspruch 3, weiter eine Mehrzahl von Lötungen (160) aufweisend, welche mit der elektronischen Komponente (150) und der thermisch leitfähigen Platte (120) verbunden sind, wobei jede Lötung (160) mit einer von den Auflagen (154d, 154w) verbunden ist und die Lötungen (160) die Auflagen (154d, 154w) und die Metallstrukturlage (110) berühren.

5. Die Leiterplatte (100) gemäß Anspruch 3, wobei ein Bereich der Bodenfläche (B1) kleiner ist als ein Bereich der Ebene (122), die vom elektrisch isolierenden Material (140) abgedeckt ist.

6. Eine Leiterplatte (100), aufweisend
zumindest eine Metallstrukturlage (110),
eine thermisch leitfähige Platte (420), welche eine Ebene (422) hat,
zumindest eine elektrisch isolierende Lage (130), welche zwischen der Metallstrukturlage (110) und der Ebene (422) angeordnet ist und partiell die Ebene (422) abdeckt, und
zumindest ein elektrisch isolierendes Material (140), welches die Ebene (422) dort abdeckt, wo sie nicht von der elektrisch isolierenden Lage (130) abgedeckt ist, und welches die thermisch leitfähige Platte (420) kontaktiert, wobei die elektrisch isolierende Lage (130) das elektrisch isolierende Material (140) exponiert und eine thermische Leitfähigkeit des elektrisch isolierenden Materials (140) größer ist als eine thermische Leitfähigkeit der elektrisch isolierenden Lage (130), **dadurch gekennzeichnet, dass**
die Leiterplatte weiter aufweist
zumindest eine innere Metallstrukturlage (470), welche zwischen der Metallstrukturlage (110) und der elektrisch isolierenden Lage (130) angeordnet ist,
zumindest eine äußere elektrisch isolierende Lage (480), welche zwischen der inneren Metallstrukturlage (470) und der Metallstrukturlage (110) angeordnet ist und die innere Metallstrukturlage (470) abdeckt, und
zumindest ein äußeres elektrisch isolierendes Material (490), welches zwischen der inneren Metallstrukturlage (470) und der Metallstrukturlage (110) angeordnet ist und sich innerhalb der äußeren elektrisch isolierenden Lage (480) befindet, wobei eine thermische Leitfähigkeit des äußeren elektrisch isolierenden Materials (490) größer ist als die der äußeren elektrisch isolierenden Lage (480).

7. Die Leiterplatte (100) gemäß Anspruch 6, wobei sowohl das äußere elektrisch isolierende Material (490) als auch die äußere elektrisch isolierende Lage (480) die Metallstrukturlage (110) und die innere Metallstrukturlage (470) berühren.

8. Eine Leiterplatte (100), aufweisend
zumindest eine Metallstrukturlage (110),
eine thermisch leitfähige Platte (120), welche eine Ebene (122) hat,
zumindest eine elektrisch isolierende Lage (130), welche zwischen der Metallstrukturlage (110) und der Ebene (122) angeordnet ist und partiell die Ebene (122) abdeckt, und
zumindest ein elektrisch isolierendes Material (140), welches die Ebene (122) dort abdeckt, wo sie nicht von der elektrisch isolierenden Lage (130) abgedeckt ist, und welches die thermisch leitfähige Platte (120) kontaktiert, wobei die elektrisch isolierende Lage (130) das elektrisch isolierende Material (140) exponiert und eine thermische Leitfähigkeit des elektrisch isolierenden Materials (140) größer ist als eine thermische Leitfähigkeit der elektrisch isolierenden Lage (130), **dadurch gekennzeichnet, dass**
die thermisch leitfähige Platte (220) eine thermisch leitfähige Lage (222) und eine Hauptkörperlage (224) aufweist und sich die thermisch leitfähige Lage (222) zwischen der Hauptkörperlage (224) und der elektrisch isolierenden Lage (130) befindet und das elektrisch isolierende Material (140) berührt, wobei die thermisch leitfähige Lage (222) eine Kohlenstoffmateriallage ist.

9. Die Leiterplatte (100) gemäß Anspruch 8, wobei ein Bereich der Bodenfläche (B2) größer ist als ein Bereich der Ebene (122), die vom elektrisch isolierenden Material (140) abgedeckt ist.

10. Die Leiterplatte (100) gemäß Anspruch 8, wobei der Komponentenhauptkörper (152) weiter eine Seitenfläche (S1) hat, die mit der Bodenfläche (B2) verbunden ist, und das elektrisch isolierende Material (140) nicht von der Seitenfläche (S1) ausgehend vorsteht.

11. Die Leiterplatte (100) gemäß Anspruch 8, wobei das elektrisch isolierende Material (140) weiter die Metallstrukturlage (110) berührt.

12. Die Leiterplatte (100) gemäß Anspruch 8, weiter zumindest eine elektronische Komponente (150) aufweisend, wobei die elektronische Komponente aufweist:
einen Komponentenhauptkörper (152), welcher eine Bodenfläche (B1) hat, und
eine Mehrzahl von Auflagen (154d, 154w), welche an der Bodenfläche (B1) angeordnet sind und elektrisch mit der Metallstrukturlage (110) verbunden sind, wobei zumindest eine der Auflagen (154d, 154w) thermisch mit dem elektrisch isolierenden Material (140) gekuppelt ist.

13. Die Leiterplatte (100) gemäß Anspruch 12, weiter eine Mehrzahl von Lötungen (160) aufweisend, welche mit der elektronischen Komponente (150) und der thermisch leitfähigen Platte (120) verbunden sind, wobei jede Lötung (160) mit einer der Auflagen (154d, 154w) verbunden ist und die Lötungen (160) die Auflagen (154d, 154w) und die Metallstrukturlage (110) berühren.

## Revendications

1. Carte de circuit (100) comprenant,
au moins une couche de motif métallique (110) ;
une plaque thermiquement conductrice (320), ayant un plan (322) ;
au moins une couche électriquement isolante (130), disposée entre la couche de motif métallique (110) et le plan (322) et recouvrant partiellement le plan (322) ; et
au moins un matériau électriquement isolant (140), recouvrant le plan (322) où il n'est pas recouvert par la couche électriquement isolante (130), et étant en contact avec la plaque thermiquement conductrice (320), dans laquelle la couche électriquement isolante (130), expose le matériau électriquement isolant (140), et la conductivité thermique du matériau électriquement isolant (140) est supérieure à la conductivité thermique de la couche électriquement isolante (130), **caractérisée en ce que** la plaque thermiquement conductrice (320) comprend :
une pluralité de substrats thermiquement conducteurs (324), un des substrats thermiquement conducteurs (324) ayant le plan (322) ;
au moins un motif thermiquement conducteur (326), disposé entre les substrats thermiquement conducteurs (324) ; et
au moins une couche électriquement isolante interne (328), disposée entre les substrats thermiquement conducteurs (324), le motif thermiquement conducteur (326) et la couche électriquement isolante interne (328) étant en contact avec les substrats thermiquement conducteurs (324), et la conductivité thermique du motif thermiquement conducteur (326) est supérieure à la conductivité thermique de la couche électriquement isolante interne (328).

2. Carte de circuit (100) selon la revendication 1, dans laquelle le matériau électriquement isolant (140) est également en contact avec la couche de motif métallique (110).

3. Carte de circuit (100) selon la revendication 1, comprenant en outre au moins un composant électronique (150), le composant électronique (150) comprenant :
un corps principal de composant (152), ayant une surface inférieure (B1) ; et
une pluralité de plots (154d, 154w), disposés sur la surface inférieure (B1) et électriquement connectés à la couche de motif métallique (110), au moins un des plots (154d, 154w) étant thermiquement couplé au matériau électriquement isolant (140).

4. Carte de circuit (100) selon la revendication 3, comprenant en outre une pluralité de brasures (160) connectées au composant électronique (150) et à la plaque thermiquement conductrice (120),
chaque brasure (160) étant connectée à un des plots (154d, 154w), et les brasures (160) étant en contact avec les plots (154d, 154w) et la couche de motif métallique (110).

5. Carte de circuit (100) selon la revendication 3, dans laquelle l'aire de la surface inférieure (B1) est inférieure à l'aire du plan (122) recouverte par le matériau électriquement isolant (140).

6. Carte de circuit (100) comprenant
au moins une couche de motif métallique (110) ;
une plaque thermiquement conductrice (420), ayant un plan (422) ;
au moins une couche électriquement isolante (130), disposée entre la couche de motif métallique (110) et le plan (422) et recouvrant partiellement le plan (422) ; et
au moins un matériau électriquement isolant (140), recouvrant le plan (422) où il n'est pas recouvert par la couche électriquement isolante (130), et étant en contact avec la plaque thermiquement conductrice (420), dans laquelle la couche électriquement isolante (130) expose le matériau électriquement isolant (140), et la conductivité thermique du matériau électriquement isolant (140) est supérieure à la conductivité thermique de la couche électriquement isolante (130), **caractérisée en ce que** la carte de circuit comprend en outre
au moins une couche de motif métallique interne (470), disposée entre la couche de motif métallique (110) et la couche électriquement isolante (130) ;
au moins une couche électriquement isolante externe (480), disposée entre la couche de motif métallique interne (470) et la couche de motif métallique (110), et recouvrant la couche de motif métallique interne (470) ; et
au moins un matériau électriquement isolant externe (490), disposé entre la couche de motif métallique interne (470) et la couche de motif métallique (110) et situé à l'intérieur de la couche électriquement isolante externe (480), la conductivité thermique du matériau électriquement isolant externe (490) étant supérieure à celle de la couche électriquement isolante externe (480).

7. Carte de circuit (100) selon la revendication 6, dans laquelle le matériau électriquement isolant externe (490) et la couche électriquement isolante externe (480) sont tous deux en contact avec la couche de motif métallique (110) et la couche de motif métallique interne (470).

8. Carte de circuit (100) comprenant,
au moins une couche de motif métallique (110) ;
une plaque thermiquement conductrice (120), ayant un plan (122) ;
au moins une couche électriquement isolante (130), disposée entre la couche de motif métallique (110) et le plan (122) et recouvrant partiellement le plan (122) ; et
au moins un matériau électriquement isolant (140), recouvrant le plan (122) où il n'est pas recouvert par la couche électriquement isolante (130), et étant en contact avec la plaque thermiquement conductrice (120), dans laquelle la couche électriquement isolante (130) expose le matériau électriquement isolant (140), et la conductivité thermique du matériau électriquement isolant (140) est supérieure à la conductivité thermique de la couche électriquement isolante (130), **caractérisée en ce que**
la plaque thermiquement conductrice (220) comprend une couche thermiquement conductrice (222) et une couche de corps principal (224), et la couche thermiquement conductrice (222) est située entre la couche de corps principal (224) et la couche électriquement isolante (130) et est en contact avec le matériau électriquement isolant (140), la couche thermiquement conductrice (222) étant une couche de matériau carboné.

9. Carte de circuit (100) selon la revendication 8, dans laquelle l'aire de la surface inférieure (B2) est supérieure à l'aire du plan (122) recouverte par le matériau électriquement isolant (140).

10. Carte de circuit (100) selon la revendication 8, dans laquelle le corps principal de composant (152) comprend en outre une surface latérale (S1) raccordée à la surface inférieure (B2), et le matériau électriquement isolant (140) ne fait pas saillie depuis la surface latérale (S1).

11. Carte de circuit (100) selon la revendication 8, dans laquelle le matériau électriquement isolant (140) est également en contact avec la couche de motif métallique (110).

12. Carte de circuit (100) selon la revendication 8, comprenant en outre au moins un composant électronique (150), le composant électronique (150) comprenant :
un corps principal de composant (152), ayant une surface inférieure (B1) ; et
une pluralité de plots (154d, 154w), disposés sur la surface inférieure (B1) et électriquement connectés à la couche de motif métallique (110), au moins un des plots (154d, 154w) étant thermiquement couplé au matériau électriquement isolant (140).

13. Carte de circuit (100) selon la revendication 12, comprenant en outre une pluralité de brasures (160) connectées au composant électronique (150) et à la plaque thermiquement conductrice (120), chaque brasure (160) étant connectée à un des plots (154d, 154w), et les brasures (160) étant en contact avec les plots (154d, 154w) et la couche de motif métallique (110).
